# EUROPEAN PATENT APPLICATION

(11) **EP 2 469 592 A1**
(43) Date of publication of application: **27.06.2012**
(21) Application number: 10016001.9
(22) Date of filing: 23.12.2010
(51) Int. Cl.: H01L 23/66, H01L 23/053, H01L 23/13

(54) **Integrated circuit chip package device**

(71) Applicant: Karlsruher Institut für Technologie, 76131 Karlsruhe (DE)
(72) Inventor: Zwick, Thomas, 76676 Graben-Neudorf (DE); Beer, Stefan, 76135 Karlsruhe (DE)

(57) **Abstract**

The present invention relates to an integrated circuit chip package device, which comprises a package base (30) and a planar dielectric substrate (10), having at least on a first surface (11) at least one conductive antenna pattern (15) as well as metallic lines (19, 19'...), which are electrically connected by means of first flip-chip balls (50) to at least one semiconductor die (20) which each comprises at least one radio frequency (RF) chip. The metallic lines (19, 19'...) are further electrically connected by means of further flip-chip balls (51, 51') to at least two contact pads (33, 33') which form a part of the package base (30).

This arrangement allows the elimination of wire bonds and thus achieves a higher mechanical stability of the integrated circuit chip package device. Also, a solution for the heat dissipation from the at least one RF chip is achieved.

## Description

The present invention relates to an integrated circuit (IC) package device which houses at least one semiconductor die and at least one conductive antenna pattern on a planar dielectric substrate.

Advanced semiconductor technology allows designing integrated radio frequency (RF) circuits in the millimeter-wave range. Such a type of integrated circuit (IC) device which operates at microwave frequencies (300 MHz to 300 GHz) is also called a Monolithic Microwave Integrated Circuit, or MMIC. On the other hand, the size of an antenna in the millimeter-wave range approximately exhibits the same dimensions as the IC chip. As a result, the integration of a complete RF front-end into an IC chip package device has been recently targeted by various approaches. Thereby, means are important for a high performance RF interconnect from the IC chip to the antenna as well as for the transfer of heat from the IC chip through the package to the surroundings, and features which allow the antenna to radiate through a package cover.

US patent 7,088,964 B2 describes a single chip radio with integrated antenna which includes a silicon substrate, at least one antenna, at least one transceiver, baseband circuitry and at least one filter, all integrally formed on the substrate. However, high losses of the antenna integrated in the silicon substrate results in low antenna efficiency.

US patent 7,477,197 B2 discloses a package which integrates an antenna layer and an RF front-end module. The device includes a substrate having a first surface and a second surface opposite the first surface. The RF front-end module coupled to the first surface and a ground plane layer is positioned between the second surface and an insulating layer, which is located between the ground plane layer and the antenna layer. This configuration does not offer a solution for dissipating the heat from the RF chip. Additionally, a complicated setup which includes very big flip chip balls and bond wires is needed.

US patent 7,095,372 B2 describes an IC chip package which comprises a substrate including at least one layer, a semiconductor die, a terminal, and an antenna located in the package but separated from the semiconductor die. The antenna comprises a conducting pattern which consists of a curve having at least five segments and forming an angle between each adjacent segment, at least three segments being shorter than one-tenth of the longest free-space operating wavelength of the antenna.

US patent 7,119,745 B2 discloses an IC chip package device which comprises a package substrate with a ground plane formed on a surface of the package substrate where the IC chip is bonded to the surface of the package substrate. In addition, an antenna pattern is formed on a first surface of a planar substrate, which is flip-chip bonded to the IC chip in such a way that the antenna pattern faces towards the ground plane. Also, the first surface of the planar substrate is disposed parallel to, and displaced from, the ground plane. Finally, the package comprises a cover which is formed over the package substrate to encapsulate both the IC chip and the planar substrate, wherein the cover comprises an opening that exposes a portion of a second surface of the planar substrate opposite the antenna pattern. In this package device, however, wire bond interconnections are utilised for the baseband and the DC connection whereas a flip-chip interconnection is applied between the IC chip and the antenna. As a result, this device requires additional production steps while being subject to mechanical instabilities.

A solution to the mentioned problems is to realize the connections with solder balls of different size. US patent 7,782,624 B2 describes a device with a first substrate having an antenna formed on a first surface thereof while a semiconductor chip is located on a second surface thereof. In addition, a second substrate is electrically connected to the first substrate by means of copper core solder balls and otherwise separated by a resin material. Finally, the second substrate is equipped with a thermal via which radiates the heat generated in the semiconductor chip. As a result, both substrates have to be connected in a complicated way and the lower substrate requires thermal conducting vias. Additionally, a resin material is required to save the chip from environmental hazards.

US patent 7,675,465 B2 discloses an IC chip package which includes a substrate having top, middle and bottom layers. An array of millimeter-wave antennas is embedded on the top layer while a microwave integrated circuit is mounted on the bottom layer. Ball grid array (BGA) balls are used for mounting the bottom layer on a printed circuit board (PCB). In this case, however, the assembly process of the package to a printed circuit board is rather complicated and the chip is not safe from environmental hazards.

Therefore, it is the main object of the present invention to provide an integrated circuit package device which overcomes the limitations of the state of the art.

In particular, it is an object of the present invention to provide a device wherein a semiconductor die and a conductive antenna pattern, which is arranged on a planar dielectric substrate, are integrated into a standard surface mountable package.

The solution of this problem is provided by an integrated circuit package device according to claim 1. The dependent claims describe preferred features.

According to the present invention, the integrated circuit (IC) chip package device comprises
- a package base, and
- a planar dielectric substrate, having
- at least one conductive antenna pattern at least on a first surface of said planar dielectric substrate, and
- metallic lines at least on a first surface of the planar dielectric substrate which faces at least one semiconductor die wherein an RF chip is integrated,
- the metallic lines being electrically connected to the at least one semiconductor die by means of first flip-chip balls, and
- the metallic lines being further electrically connected to at least two contact pads, which form a part of the package base, by means of further flip-chip balls.

The arrangement according to the present invention allows eliminating wire bonds (which are used in the state of the art) and thus achieves a higher mechanical stability of the IC chip package device.

The frequency emitted by the conductive antenna pattern is preferably in the range from 10 GHz to 500 GHz, more preferably in the range from 50 GHz to 300 GHz.

The sizes of both the first flip-chip balls and of the further flip-chip balls are preferably in the range from 10 µm to 150 µm, more preferred in the range from 20 µm to 100 µm. All flip-chip balls preferably comprise gold, solder or another conductive adhesive.

In a preferred embodiment of the present invention, the IC chip package device comprises a cover (cap, lid) which is formed over the package base in order to encapsulate the at least one semiconductor die and the planar dielectric substrate. The cover requires comprising at least partially a material which is at least partially transparent for a frequency emitted by the conductive antenna pattern, in particular standard plastic materials.

In an alternative embodiment of the present invention, the planar dielectric substrate is employed as a cap in order to cover the package base to encapsulate the at least one semiconductor die.

Particularly in but not limited to this embodiment, gaps arising between the planar dielectric substrate and the package base or between the planar dielectric substrate and the at least one semiconductor die, respectively, are at least partially filled with a flip-chip underfill, wherein the first flip-chip balls and the further flip-chip balls are placed.

In a further preferred embodiment, the at least one semiconductor die is thermally coupled by means of a thermally conducting layer with the package base. This specific embodiment improves the transfer of heat from the at least one semiconductor die to the package base.

In a particularly preferred embodiment of the present invention, the package base possesses a cavity that is as deep as the at least one semiconductor die is high. The form of this cavity allows to arrange the surface of the at least one semiconductor die and the at least two contact pads at the same height. Thus, the interconnections from the at least one semiconductor die to the contact pads are arranged on the first surface of the planar dielectric substrate, applying the same sized flip-chip balls for both the connections from the at least one semiconductor die to the planar substrate and from the contact pads to the planar substrate. In addition, the heat dissipation from the at least one semiconductor die to the package base is guaranteed. The cavity is realised in a first option while machining the lead frame, e.g. by etching, blanking or bending. In a second option, the cavity is realised while moulding the package.

In a further preferred embodiment, the conductive antenna pattern on the first side of the planar dielectric substrate is disposed parallel to, and displaced from, the at least one semiconductor die, thus opening an air cavity between the first surface of the planar dielectric substrate and the package base. The resulting antenna with an air cavity reflector thus achieves a higher efficiency and bandwidth.

The advantage of the present invention is that this arrangement allows eliminating wire bonds. Further, the IC package device can be closed with a standard package cover. Such plastic packages, e.g. air cavity packages, are already in use in the packaging industry, and only have to be redesigned to offer the fitting cavity depth. The application of such a surface mountable package base allows an optimal heat transfer from the at least one semiconductor die with the integrated RF chip, to the outside, and, in addition, an optimal electrical interconnect from the at least one conductive antenna pattern to the at least one semiconductor die by applying flip-chip balls as interconnects, as well as radiating the RF provided by the antenna pattern through the top of the package cover.

It is noted that the advantages are achieved with a standard plastic package commonly used in the semiconductor industry.

The present invention will be more apparent from the following description of non-limiting specific embodiments with reference to the drawings.
**Fig. 1** shows a side view of an IC package device having a cover where the conductive antenna pattern is disposed parallel to, and displaced from, a semiconductor die on a single-layer planar dielectric substrate.
**Fig. 2** exhibits a side view of an IC package device having a cover where the conductive antenna pattern is disposed above the semiconductor die on a single-layer planar dielectric substrate.
**Fig. 3** displays a side view of an IC package device having a cover where the conductive antenna pattern is disposed above the semiconductor die on a multi-layer planar dielectric substrate.
**Fig. 4** exhibits a side view of an IC package device without cover where the conductive antenna pattern is disposed parallel to, and displaced from, the semiconductor die on a single-layer planar dielectric substrate.
**Fig. 5** shows a bottom view of the planar dielectric substrate (**a**) prior to the mounting of the semiconductor die, and (**b**) after the mounting of the semiconductor die.

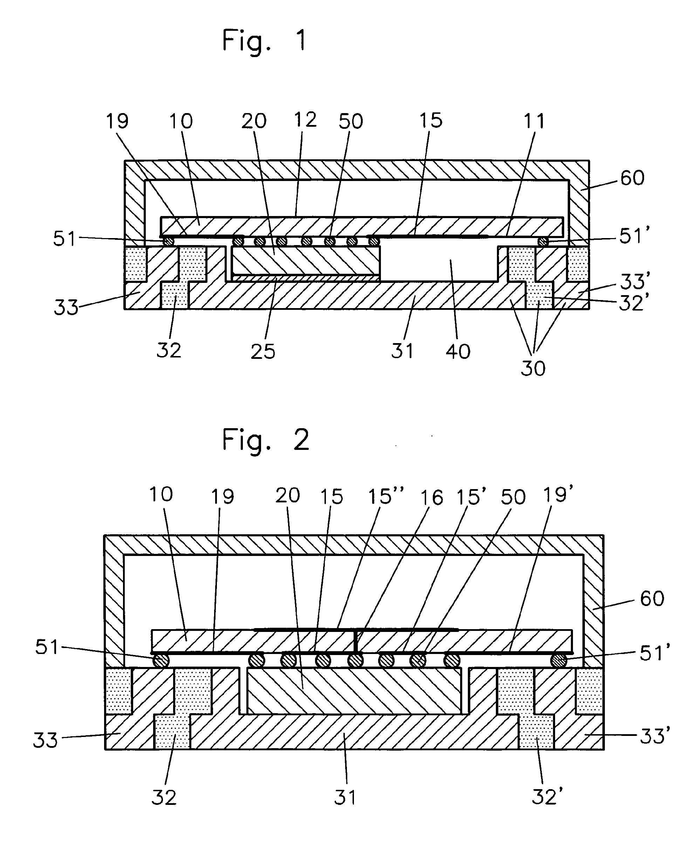

Fig. 1 shows a side view of a completely integrated circuit (IC) chip package device according to the invention which comprises a package base **30** consisting of a centre die pad **31** (also called thermal pad or ground pad), four plastic moulds **32, 32', 32 " , 32 " '** and two contact pads **33, 33'.** Introduced into the centre die pad **31** is a cavity **40** in which the semiconductor die **20,** which houses an RF chip, is placed.

The package base **30** is preferably a *Quad Flat No leads* (QFN) package, an arrangement introduced to physically and electrically connect integrated circuits (ICs) to printed circuit boards (PCBs) without through-holes. QFN packages include an exposed centre die pad in order to improve heat transfer out of the IC into the PCB.

Accordingly, the semiconductor die **20** is connected to the package base **30** either directly or through a thermal conductive adhesive layer **25** which exhibits the function of transferring heat from the semiconductor die **20** to the package base 30. In addition, the thermally conductive adhesive layer **25** equalizes any surface irregularities on the package base **30**.

A planar dielectric substrate **10** is disposed above the semiconductor die **20** and the package base **30**. On the first surface **11** of the planar dielectric substrate **10** metallic lines **19**, 19'... are provided which electrically connect the semiconductor die **20** to the two contact pads 33, 33' by means of flip chip balls **50, 51, 51**'.

The planar dielectric substrate **10** on its first side **11** further houses a conductive antenna pattern **15**. In Fig. 1 the conductive ante**n**na pattern **15** is disposed parallel to, and displaced from, the semiconductor die **20**. The centre die pad 31 acts as antenna reflector.

In this example depicted in **Fig. 1**, the cavity **40** is as deep as the semiconductor die **20** is high, which results in an arrangement wherein a surface of the semiconductor die 20, which faces the first surface **11** of the planar dielectric substrate 10, and the two contact pads **33, 33**' are at the same height. Thus, the interconnections from the semiconductor die **20** to the contact pads **33, 33'** are arranged on the first surface **11** of the planar dielectric substrate **10** by means of flip-chip balls **50, 51, 51'** of the same size in order to arrive at both connections from the semiconductor die **20** to the planar substrate **10** as well as from each of the contact pads **33, 33'** to the planar substrate **10.**

Finally, a cover (cap, lid) **60** is provided which encloses the package. The selected cover **60** at least partly consists of a material which is transparent for the RF frequency radiated by the conductive antenna pattern **15.**

**Fig. 2** exhibits a further embodiment of the present invention. In contrast with **Fig. 1****,** three separate conductive antenna patterns **15, 15', 15 "** are disposed parallel to the semiconductor die 20 on both, the first side **11** and the second side **12** of the planar dielectric substrate **10.** The conductive antenna pattern **15 "** which is arranged on the second side **12** of the planar dielectric substrate **10** is fed from the conductive antenna patterns **15, 15'** which are arranged on the first side **11** of the planar dielectric substrate **10** by a metallic via **16** or, alternatively, by electromagnetic coupling. Similar to **Fig. 1**, the first side **11** of the planar dielectric substrate **10** comprises metallic lines **19, 19'...** which electrically connect the semiconductor die **20** to the two contact pads **33, 33'** by means of flip-chip balls **50, 51, 51'.**

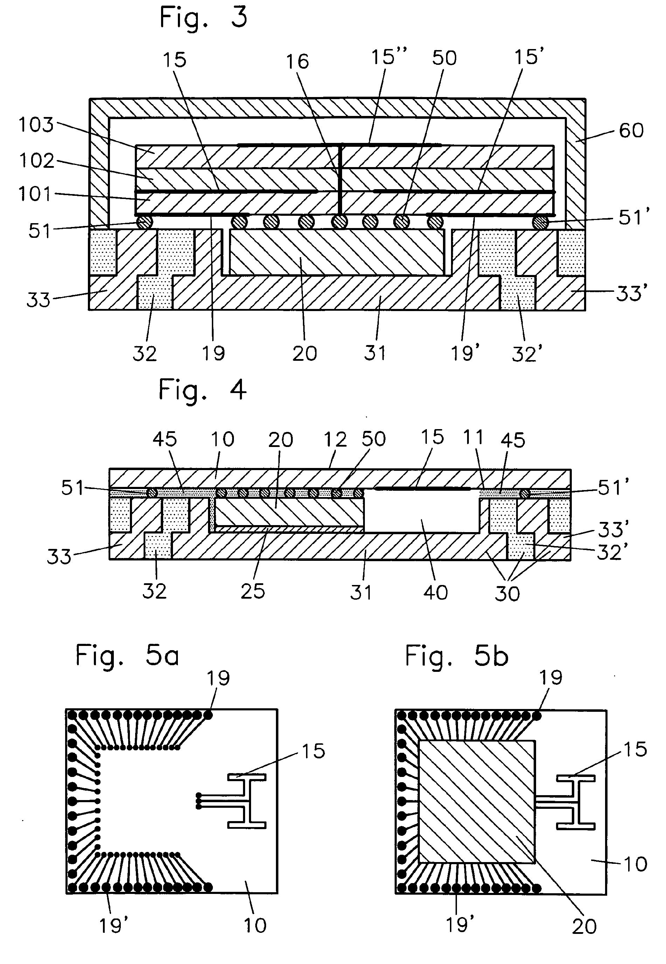

**Fig. 3** displays a further embodiment of the present invention. In contrast with **Fig. 2****,** the conductive antenna pattern **15** is arranged within a multilayer dielectric substrate which here comprises three separate layers **101, 102, 103.**

**Fig. 4** exhibits a further embodiment of the present invention. Here, the conductive antenna pattern **15** is, similar to **Fig. 1****,** disposed parallel to, and displaced from, the semiconductor die **20** on the first side **11** of a single-layer planar dielectric substrate **10.** Similar to **Fig. 1****,** the cavity **40** is as deep as the semiconductor die **20** is high, resulting in an arrangement wherein a surface of the semiconductor die **20** and the two contact pads **33, 33'** are at the same height.

In contrast with **Fig. 1**, the cover (cap, lid) **60** is omitted in this example. As a result, a flip-chip underfill **45,** preferably of a resin material, is required to partially close the remaining gap between the planar dielectric substrate **10** and the package base **30** in such a way that the cavity **40** between the planar dielectric substrate **10** and the centre die pad **31** remains. As a consequence, the IC chip package is nevertheless enclosed and does not require an additional cover **60** since the planar dielectric **substrate 10** adopts together with the flip-chip underfill **45** the function of the package cover.

**Fig. 5a** shows a bottom view of the planar dielectric substrate **10** according to **Fig. 1** with metallic lines **19, 19'...** on the planar dielectric substrate **10** which function as electrical interconnections from the semiconductor die **20** to the contact pads **33, 33'...** and a double dipole structure employed as conductive antenna pattern **15.**

**Fig. 5 b** displays a bottom view of the planar dielectric substrate **10** as depicted in **Fig. 5a** after mounting the semiconductor die **20** which houses the RF chip in a way that it faces the first surface **11** of the planar dielectric substrate **10.**

### List of reference signs

- **10**: planar dielectric substrate
- **101, 102, 103**: separate layers in case of a multi-layered planar dielectric substrate 10
- **11**: first surface (side) of the planar dielectric substrate 10
- **12**: second surface (side) of the planar dielectric substrate 10
- **15, 15', 15 "**: conductive antenna patterns
- **16**: metallic via
- **19, 19'...**: metallic lines
- **20**: semiconductor die (with integrated RF chip)
- **25**: thermal conductive adhesive layer
- **30**: package base
- **31**: centre die pad (also called thermal pad or ground pad)
- **32, 32'...**: plastic moulds
- **33, 33'...**: contact pads (also called package pads)
- **40**: cavity
- **45**: flip-chip underfill
- **50**: first flip-chip balls
- **51, 51'**: further flip-chip balls
- **60**: cover (cap, lid)

## Claims

1. Integrated circuit chip package device, comprising a package base (30) and a planar dielectric substrate (10) having at least on a first surface (11) at least one conductive antenna pattern (15) as well as metallic lines (19, 19'...), which are electrically connected by means of first flip-chip balls (50) to at least one semiconductor die (20), **characterized in that** the metallic lines (19, 19'...) are further electrically connected by means of further flip-chip balls (51, 51') to at least two contact pads (33, 33') which form a part of the package base (30) .

2. Device according to claim 1, **characterized in that** a cover (60) is formed over the package base (30) to encapsulate the at least one semiconductor die (20) and the planar dielectric substrate (10), wherein the cover (60) at least partially comprises a material which is at least partially transparent for a frequency emitted by the at least one conductive antenna pattern (15).

3. Device according to claim 1, **characterized in that** the planar dielectric substrate (10) covers the package base (30) to encapsulate the at least one semiconductor die (20) .

4. Device according to one of the claims 1 to 3, **characterized in that** gaps arising between the planar dielectric substrate (10) and the package base (30) or between the planar dielectric substrate (10) and the at least one semiconductor die (20) are at least partially filled with a flip-chip underfill (45), wherein the first flip-chip balls (50) and the further flip-chip balls (51, 51') are placed.

5. Device according to one of the claims 1 to 4, **characterized in that** the at least one conductive antenna pattern (15) at least on the first surface (11) of the planar dielectric substrate (10) is disposed parallel to, and displaced from, the at least one semiconductor die (20), resulting in a cavity (40) between the first surface (11) of the planar dielectric substrate (10) and the package base (30).

6. Device according to claim 5, **characterized in that** the cavity (40) between the first surface (11) of the planar dielectric substrate (10) and the package base (30) is as deep as the at least one semiconductor die (20) is high, resulting in a surface of the at least one semiconductor die (20), which faces the first surface (11) of the planar dielectric substrate (10), and the at least two contact pads (33, 33') being at the same height.

7. Device according to claim 6, **characterized in that** the metallic lines (19, 19'...), which are arranged on the first surface (11) of the planar dielectric substrate (10), are electrically connected to the at least one semiconductor die (20) by means of the first flip-chip balls (50) and to the at least two contact pads (33, 33') by means of the further flip-chip balls (51, 51'), where the first flip-chip balls (50) and further flip-chip balls (51, 51') are of the same size.

8. Device according to one of the claims 1 to 7, **characterized in that** the size of the first flip-chip balls (50) and the size of the further flip-chip balls (51, 51') are each in the range from 10 µm to 150 µm.

9. Device according to claim 8, **characterized in that** the size of the first flip-chip balls (50) and the size of the further flip-chip balls (51, 51') are each in the range from 20 µm to 100 µm.

10. Device according to one of the claims 1 to 9, **characterized in that** the at least one semiconductor die (20) is thermally coupled by means of a thermally conducting layer (25) with the package base (30).

11. Device according to one of the claims 1 to 10, **characterized in that** the frequency emitted by the at least one conductive antenna pattern (15) is in the range from 10 GHz to 500 GHz.

12. Device according to claim 11, **characterized in that** the frequency emitted by the at least one conductive antenna pattern (15) is in the range from 50 GHz to 300 GHz.
